# EUROPÄISCHE PATENTSCHRIFT

(11) **EP 3 431 200 B1**
(45) Veröffentlichungstag und Bekanntmachung des Hinweises auf die Patenterteilung: **24.06.2020**
(21) Anmeldenummer: 18184416.8
(22) Anmeldetag: 19.07.2018
(51) Int. Cl.: B08B 17/06, D06M 11/79, H01L 31/048, H02S 40/10

(54) **OBERFLÄCHENBESCHICHTUNG UND VERFAHREN ZUR VERRINGERUNG DER VERSCHMUTZUNGSANFÄLLIGKEIT EINER OBJEKTOBERFLÄCHE**
SURFACE COATING AND METHOD FOR REDUCING THE CONTAMINATION TENDENCY OF THE SURFACE OF AN OBJECT
REVÊTEMENT DE SURFACE ET PROCÉDÉ DE RÉDUCTION DE LA TENDANCE AUX SALISSURES D'UNE SURFACE D'OBJET

(30) Priorität: 20.07.2017 EP 17182291
(43) Veröffentlichungstag der Anmeldung: 23.01.2019
(73) Patentinhaber: Fraunhofer-Gesellschaft zur Förderung der angewandten Forschung e.V., 80686 München (DE)
(72) Erfinder: Ilse, Klemens, 06108 Halle (DE); Naumann, Volker, 06210 Halle/Saale (DE); Hagendorf, Christian, 06108 Halle (Saale) (DE); Glaubitt, Walther, 97276 Margetshöchheim (DE); Mirza, Mark, 91480 Markt Taschendorf (DE)
(74) Vertreter: Gagel, Roland

(56) Entgegenhaltungen:
- DE-A1-102006 005 614
- US-A1- 2013 199 612
- WALTHER GLAUBITT ET AL: "Anti-soiling effect of porous SiOcoatings prepared by sol-gel processing", JOURNAL OF SOL-GEL SCIENCE AND TECHNOLOGY, KLUWER ACADEMIC PUBLISHERS, BO, Bd. 59, Nr. 2, 19. Mai 2011 (2011-05-19), Seiten 239-244, XP019935033, ISSN: 1573-4846, DOI: 10.1007/S10971-011-2489-5
- SWAGATA BANERJEE ET AL: "Self-cleaning applications of TiO2 by photo-induced hydrophilicity and photocatalysis", APPLIED CATALYSIS B: ENVIRONMENTAL, Bd. 176-177, 1. Oktober 2015 (2015-10-01), Seiten 396-428, XP055293956, AMSTERDAM, NL ISSN: 0926-3373, DOI: 10.1016/j.apcatb.2015.03.058
- BAHATTAB MOHAMMED A ET AL: "Anti-soiling surfaces for PV applications prepared by sol-gel processing: Comparison of laboratory testing and outdoor exposure", SOLAR ENERGY MATERIALS AND SOLAR CELLS, ELSEVIER SCIENCE PUBLISHERS, AMSTERDAM, NL, Bd. 157, 18. Juli 2016 (2016-07-18), Seiten 422-428, XP029730705, ISSN: 0927-0248, DOI: 10.1016/J.SOLMAT.2016.07.004

## Beschreibung

### Technisches Anwendungsgebiet

Die vorliegende Erfindung betrifft eine Oberflächenbeschichtung mit verringerter Verschmutzungsanfälligkeit, die durch eine nanoporöse Schicht oder Schichtfolge gebildet ist, sowie ein Verfahren zur Verringerung der Verschmutzungsanfälligkeit einer Objektoberfläche, insbesondere der Oberfläche eines Photovoltaikmoduls. Die Oberflächenbeschichtung sowie das Verfahren dienen allgemein der Reduzierung der Verschmutzung von Oberflächen durch Haftung von Partikeln und Schmutz, insbesondere auf transparenten oder spiegelnden Oberflächen wie beispielsweise bei Photovoltaikmodulen, Solarthermie-Spiegeln, Fenster-und Architekturglas, Gewächshäusern oder Museumsvitrinen.

Die der Erfindung zugrundeliegende Problematik wird im Folgenden anhand von Photovoltaikmodulen erläutert, kann aber ohne weiteres auf andere Anwendungen übertragen werden, in denen ungewollte Partikelhaftung zu Beeinträchtigungen führt. Hierzu zählen beispielsweise auch Prozessstäube in industriellen Produktionsanlagen wie beispielsweise Allergene in der Lebensmittelproduktion, Farbpulver-Rückstände in der Farbproduktion oder Staubpartikel-Pharmazieprodukte.

Photovoltaikmodule (PV-Module) werden unter freiem Himmel installiert. Ihre Oberflächen sind damit den lokalen Witterungsbedingungen ausgesetzt. Je nach Standort können sich diese stark unterscheiden, da unter anderem Umgebungstemperatur, Luftfeuchtigkeit, typische Windgeschwindigkeiten, Sonneneinstrahlung sowie Verunreinigungen der Luft stark variieren können. Staubbelastungen bzw. Luftverschmutzungen können sowohl natürlichen Ursprungs sein, wie beispielsweise mineralische Stäube in Wüstenregionen, oder auch künstlicher bzw. menschen-bedingter Herkunft sein, wie beispielsweise Rußpartikel aufgrund von Straßenverkehr oder von Industrieabgasen. Entsprechend der Standortbedingungen kommt es durch Ablagerung von Staubpartikeln zu einer Verschmutzung von Oberflächen. Dieser Effekt wird unter anderem bei PV-Modulen auch als "Soiling" bezeichnet. Die Anlagerungen an den Oberflächen wiederum führen durch Streu- und Absorptionsprozesse zu einer Verschattung des einfallenden Sonnenlichtes, was sich bei PV-Modulen direkt in Leistungsverlusten niederschlägt. Diese können vor allem in extremen Klimaten wie beispielsweise Wüstenregionen sehr hoch sein und sich auf über 1% relativen Leistungsverlust pro Tag belaufen. Die Anhaftung von Staubpartikeln wird durch kondensierte Feuchtigkeit und resultierende Kapillarkräfte stark begünstigt. Durch die zyklische Einwirkung von Feuchtigkeit (Betauung) und Trocknung kann es zusätzlich zum Festbacken von Staubpartikeln durch Zementationsprozesse mit dauerhaften und schwer zu reinigenden Verschmutzungen kommen.

### Stand der Technik

Zur Verringerung der Verschmutzung oder der Verschmutzungsanfälligkeit von Oberflächen unter Outdoor-Bedingungen sind bisher unterschiedliche Verfahren bekannt, die sich in drei Kategorien einordnen lassen. Bei der ersten Kategorie wird eine natürliche Reinigungswirkung durch Regen, Wind und/oder Schnee ausgenutzt. Die zweite Kategorie setzt eine aktive manuelle oder automatisierte Reinigung ein, die mit Wasser, mit Druckluft, mechanisch mit Bürsten oder auch mit elektrischen Feldern (EDS) erfolgen kann. Die dritte Kategorie betrifft eine passive VerschmutzungsReduktion durch geeignete Beschichtungen der Oberfläche. Die vorliegende Erfindung lässt sich in die dritte Kategorie einordnen. Als solche verstärkt sie prinzipiell die Wirkung von natürlichen Reinigungsprozessen wie z.B. Reinigung durch Wind oder durch Niederschlag. Im Folgenden wird lediglich diese dritte Kategorie der funktionalen Beschichtungen explizit betrachtet.

Aus wissenschaftlicher Perspektive existiert eine große Fülle an Schichten, welche sich potentiell als Anti-Schmutz-Beschichtungen eignen und für eine Anwendung bei PV-Modulen auch transparente Eigenschaften aufweisen. Hierbei liegt der Fokus auf Schichten mit entweder (super)hydrophilen, (super)-hydrophoben oder photokatalytischen Eigenschaften. Beispiele für derartige Schichten können beispielsweise den Veröffentlichungen von S. Nishimoto et al., "Bioinspired self-cleaning surfaces with superhydrophobicity, superoleophobicity, and superhydrophilicity" in: RSC Adv 3 (2013), Nr. 3, S. 671-690, oder von S. Banerjee et al., "Self-cleaning applications of TiO2 by photo-included hydrophilicity and photocatalysis" in: Applied Catalysis B: Environmental 176-177 (2015), S. 396-428, entnommen werden. Bei den meisten dieser Schichten wird über eine mikro- oder nanoskopische Rauheit der Oberfläche und die damit verknüpfte reduzierte Kontaktfläche zwischen Verunreinigung (z.B. Staubpartikel) und der Oberfläche eine Haftungsreduktion erreicht. Darüber hinaus wird von einer selbstreinigenden Wirkung durch den häufig über chemische Funktionalisierung erreichten (super)-hydrophilen oder (super)hydrophoben Charakter der jeweiligen Schicht ausgegangen. Diese wird analog zum Lotus-Effekt meist mit abperlenden Wassertropfen inklusive Schmutz-Mitnahme bzw. auf einem Wasserfilm abgleitenden Schmutzpartikeln beschrieben. Bei photokatalytisch aktiven Schichten kommt es unter Lichteinwirkung zu einer chemischen Veränderung der Oberfläche, welche neben einer Hydrophilierung der Oberfläche auch zum Aufbrechen organischer Verbindungen führen kann und somit das Anhaften organischer Kombinationen minimiert.

Verglichen zur wissenschaftlichen Beachtung existiert nur eine kleine Zahl an kommerziell verfügbaren selbst-reinigenden Anti-Schmutz-Schichten mit transparenten Eigenschaften. Beispiele hierfür sind in K. Midtal et al., "Self-cleaning glazing products: A state-of-the-art review and future research pathways" in: Solar Energy Materials and Solar Cells 109 (2013), S. 126-141, angeführt. Es sind jedoch bisher keine kommerziellen Schichten bekannt, welche auch unter extremen Outdoor-Bedingungen, wie sie beispielsweise in Wüstenregionen herrschen, ausreichend lang anhaltende selbstreinigende Eigenschaften aufweisen.

Aus der US 2013/199612 A1 ist ein hydrophobisches Substrat bekannt, das an der Oberfläche einen Selbstreinigungseffekt und eine niedrige Reflexion aufweist. Das Substrat weist eine nanostrukturierte Oberfläche auf, die mit einer hydrophoben Schicht beschichtet ist. Durch die hydrophobe Schicht wird die Selbstreinigung, durch die Nanostrukturierung die geringe Reflektivität erzeugt.

Zentraler Bestandteil für die selbstreinigende Funktion der bekannten hydrophoben, hydrophilen und photokatalytischen Schichten ist das ausreichende Vorhandensein von Wasser, welches beispielsweise durch Niederschlag zur Verfügung gestellt wird. Insbesondere in Wüstenregionen steht Wasser allerdings nur begrenzt bzw. gar nicht zur Verfügung. Ohne regelmäßigen Niederschlag ist die Wirksamkeit dieser Schichten stark begrenzt, auch wenn es bei teilweiser hoher Luftfeuchtigkeit zur Kondensation von Wassertropfen kommt. Darüber hinaus verlieren insbesondere superhydrophobe und superhydrophile Schichten aufgrund von Stress-Faktoren und Witterungseinflüssen wie Feuchtigkeit, Wind oder mechanischen Verschleiß, z.B. durch Abrieb, schnell ihre Eigenschaften, so dass sie vor allem im Feld nicht zu der erhofften Verschmutzungsreduktion führen. Obwohl "Soiling" eine Vielzahl installierter Photovoltaikanlagen betrifft und Gegenstand wissenschaftlicher Forschung an einer Reihe von renommierten Instituten ist, werden in der Praxis bisher kaum nichtmechanische Verfahren eingesetzt, um PV-Module im Feld frei von Staub zu halten oder zu reinigen.

Aus M.A. Bahattab et al., "Anti-soiling surfaces for PV applications prepared by sol-gel processing: Comparison of laboratory testing and outdoor exposure", in: Solar Energy Materials and Solar Cells 157 (2016), S. 422-428, und W. Glaubitt et al., "Anti-soiling effect of porous SiO2 coatings prepared by sol-gel processing", in: Journal of Sol-Gel Science and Technology 59 (2011), Nr. 2, S. 239-244, sind nanoporöse Schichten auf Siliziumoxidbasis als Oberflächenbeschichtung bekannt, die mit Hilfe von Sol-Gel-Verfahren hergestellt wurden und Nanopartikel mit bimodaler Verteilung aufweisen. Diese hydrophilen nanoporösen Schichten besitzen auf Glasoberflächen anti-reflektierende Eigenschaften und zeigten in Feldversuchen eine geringere Verschmutzung der Oberflächen im Vergleich zu unbeschichteten Gläsern.

Die Aufgabe der vorliegenden Erfindung besteht darin, eine Oberflächenbeschichtung sowie ein Verfahren zur Verringerung der Verschmutzungsanfälligkeit einer Objektoberfläche anzugeben, die ihre Wirkung auch unter extremen Umgebungsbedingungen wie beispielsweise in Wüstenregionen lang andauernd erzielen und sich auch - bei Nutzung entsprechend optisch transparenter Schichtmaterialien - für den Einsatz in der Photovoltaik und in der Solarthermie eignen.

### Darstellung der Erfindung

Die Aufgabe wird mit der Oberflächenbeschichtung und dem Verfahren gemäß den Patentansprüchen 1 und 14 gelöst. Vorteilhafte Ausgestaltungen der Oberflächenbeschichtung sowie des Verfahrens sind Gegenstand der abhängigen Patentansprüche oder lassen sich der nachfolgenden Beschreibung sowie den Ausführungsbeispielen entnehmen.

Die vorgeschlagene Oberflächenbeschichtung mit verringerter Verschmutzungsanfälligkeit ist durch eine nanoporöse Schicht oder Schichtfolge gebildet, die eine hydrophobe Oberfläche aufweist und im Inneren hydrophil als Wasserspeicherschicht mit einer Wasserspeicherkapazität von wenigstens 60*10⁻⁶ l/m² ausgebildet ist. Der Begriff nanoporös umfasst hierbei insbesondere Porengrößen, die im Bereich ≤ 100nm liegen und die Aufnahme von Wasser aufgrund von Kapillarkräften ermöglichen. Die angegebene minimale Wasserspeicherkapazität, auch als minimales Wasserspeichervolumen bezeichnet, entspricht einem Wert von 60 nm (Wassersäule), da 1 l/m² = 1 mm (Wassersäule) beträgt. Bei dem vorgeschlagenen Verfahren zur Verringerung der Verschmutzungsanfälligkeit einer Objektoberfläche wird eine derartige Oberflächenbeschichtung auf die Objektoberfläche aufgebracht.

Für Staub-Partikel im ein- und zweistelligen Mikrometer-Größenbereich, wie sie bspw. typischerweise in Wüstenklimaten vorkommen, können bei entsprechender Luftfeuchtigkeit oder bei Betauungsvorgängen die entstehenden Kapillarkräfte zwischen diesen Partikeln und der jeweiligen Oberfläche um Größenordnungen größer sein als andere Kräfte wie Gewichtskraft, elektrostatische, thermische oder Van-der-Waals-Kräfte. Darüber hinaus ist auch für das Zustandekommen bestimmter chemischer Bindungen, wie sie bei Zementationsprozessen auf den Oberflächen von PV-Modulen in Wüstenregionen beobachtet werden, das Vorhandensein von Wasser in Kombination mit Stäuben eine notwendige Voraussetzung. Das Vorhandensein von Wasser an der Oberfläche, auch in Form mikroskopischer Tröpfchen und Filme wie sie beispielsweise durch Kondensation entstehen, wird hier daher als Hauptursache für die Haftung von Verunreinigungen auf den Oberflächen angesehen. Die Vermeidung der Benetzung der Oberfläche mit flüssigem Wasser stellt deswegen im Rahmen der vorliegenden Erfindung einen zentralen Ansatzpunkt zur Verschmutzungsreduktion dar. Ein lateraler Abtransport von Wassertropfen und -filmen ist jedoch für nur leicht geneigte Oberflächen, wie sie typischerweise bei PV-Modulen vorliegen, sowie in Wüstenregionen mit entsprechend geringem Niederschlag nur begrenzt möglich.

Der vorgeschlagenen Oberflächenbeschichtung und dem zugehörigen Verfahren liegt daher die Idee eines vertikalen Transports der Feuchtigkeit bezogen auf die Oberfläche der Schicht und die Speicherung des flüssigen Wassers in den inneren, hydrophilen Bereichen der Schicht in Verbindung mit einem thermischen Feuchtigkeitsmanagement zugrunde. Die Anti-Haft-Wirkung wird dabei durch die hydrophobe Oberfläche des nanoporösen Schichtaufbaus mit entsprechender Oberflächenrauheit erreicht. Die hydrophilen Eigenschaften des Inneren der Schicht bewirken eine Bindung und Speicherung von kondensiertem Wasser im Inneren der Schicht, die damit als Wasserspeicherschicht dient. Auf diese Weise wird die Oberfläche über einen längeren Zeitraum trocken bzw. frei von kondensierten Wassertröpfchen oder -filmen gehalten, so dass die obigen Zementationsprozesse vermieden werden. Ein Leeren des Feuchtigkeitsspeichers (Wasserspeicherschicht) wird bei trockenen und warmen Umgebungsbedingungen durch das Ausgasen von Wasserdampf realisiert. Bei PV-Modulen erfolgt dies automatisch bei Sonneneinstrahlung und wird durch die typischen erhöhten Temperaturen von PV-Modulen von bis zu 80°C (zur Mittagszeit) unterstützt. Die Entfernung des Wassers aus der Wasserspeicherschicht der Oberflächenbeschichtung kann selbstverständlich auch durch andere Wärmequellen erfolgen, beispielsweise durch eine regelmäßige künstliche Beheizung. Mögliche optische Verluste durch eine Änderung der Brechungsindizes bei mit Wasser gefüllten Poren der nanoporösen Schicht werden dabei in Kauf genommen, da die Wassereinlagerung bei dieser Anwendung in der Regel in den kühlen Nachtstunden ohne Sonneneinstrahlung erfolgt.

Die nanoporöse Schicht oder Schichtfolge kann dabei beispielsweise aus wenigstens zwei übereinanderliegenden Schichten gebildet sein, von denen die obere Schicht hydrophob und die untere Schicht hydrophil ausgebildet ist. Es kann sich bei der nanoporösen Schicht auch um eine einzige Schicht handeln, die einen graduellen Verlauf der hydrophoben und hydrophilen Eigenschaften ausgehend von der Oberfläche bis ins Innere Schicht aufweist. Der hydrophobe/hydrophile Schichtgradient wird entsprechend so eingestellt, dass die nanoporöse Schicht oder Schichtfolge eine für die Verringerung der Verschmutzungsanfälligkeit ausreichende Wasserspeicherkapazität im Inneren aufweist.

Das Wasserspeichervolumen und damit auch die Wasserspeicherkapazität werden maßgeblich von der Schichtdicke und der Porosität der Schicht bestimmt. Die Porosität der nanoporösen Schicht oder Schichtfolge der vorgeschlagenen Oberflächenbeschichtung liegt vorzugsweise im Bereich 30-70%, besonders bevorzugt bei 50% ± 5%. Die für eine bestimmte Wasserspeicherkapazität erforderliche Schichtdicke erhält man bei einer Porosität von X% durch Multiplikation der Wassersäule mit dem Faktor 100/X, bei einer Porosität von 50% somit durch Multiplikation der Wassersäule mit dem Faktor 2.

Die Auslegung der Oberflächenbeschichtung hinsichtlich der Wasserspeicherkapazität orientiert sich bei einem Einsatz von Photovoltaik-Modulen an den Taumengen, die in der entsprechenden örtlichen Region in einer Nacht anfallen. Im Folgenden werden beispielhafte Wertebereiche (Wassersäule) für die Wasserspeicherkapazität angegeben, für die die nanoporöse Schicht oder Schichtfolge bei der vorgeschlagenen Oberflächenbeschichtung, insbesondere für Photovoltaikmodule, ausgebildet sein kann.
∘ Niedrige Speicherkapazität: 60 nm - 1 µm
∘ Mittlere Speicherkapazität: 1 µm - 0,1 mm Wassersäule, angelehnt an typischer mittlerer Taumenge von 0,1 mm für eine Nacht für optimierte, planare und isolierte Kondensor-Oberflächen an relevanten Standorten (z.B. Jerusalem oder Küstengebiet in Korsika)
∘ Hohe Speicherkapazität: 0,1 mm - 0,37 mm
∘ Sehr hohe Speicherkapazität: 0,37 mm - 0,8 mm
∘ Maximale Speicherkapazität: 0,8 mm, angelehnt am theoretisch möglichen absoluten Maximum für eine tägliche Taumenge

Die Schichtdicke des hydrophilen Bereiches der nanoporösen Schicht oder Schichtfolge liegt vorzugsweise bei mindestens 120 nm. Unter dem Begriff des hydrophilen Bereichs ist dabei die hydrophile Schicht bei einer Schichtfolge aus einer hydrophoben und einer hydrophilen Schicht und der hydrophile Schichtbereich bei einer Schicht mit einem graduellen Verlauf der hydrophoben und hydrophilen Eigenschaften zu verstehen, wobei die hydrophile Schicht bzw. der hydrophile Schichtbereich immer zwischen der Objektoberfläche, z.B. einer Glasscheibe, und der hydrophoben Schicht liegt.

Für die Anwendung bei Photovoltaik-Modulen oder anderen eine optische Durchlässigkeit zur Objektoberfläche erfordernden Objekten ist die nanoporöse Schicht oder Schichtfolge aus optisch transparentem Material gebildet. Vorzugsweise wird die Schichtdicke der nanoporösen Schicht oder Schichtfolge dabei so gewählt, dass sie eine Antireflexbeschichtung für optische Strahlung auf der Objektoberfläche bildet. Besonders vorteilhaft für die Antireflex-Wirkung bei gleichzeitiger Schichtstabilität ist hierbei eine Porosität der Schicht von ca. 50% (50% ± 5%).

Durch die Einstellung eines Gradienten der Benetzbarkeit/Hydrophobizität bei der vorgeschlagenen Oberflächenbeschichtung wird eine trockene Oberfläche der Beschichtung und somit des Objektes erzielt. Insbesondere bei mikroskopisch kleinen Wassertröpfchen, wie sie z.B. bei Kondensationsvorgängen entstehen, erfolgt ein schneller Abtransport des Wassers in die Schicht hinein, in der das Wasser dann gespeichert wird. Die Verringerung der Wasserbelegung bzw. der Residenzzeit an der Oberfläche wiederum reduziert den Hauptmechanismus der Haftung von Schmutzpartikeln durch Kapillarkräfte und verhindert gleichzeitig nachfolgende Zementationsprozesse. Die reduzierten Haftkräfte (fehlende Kapillarkraft) führen dazu, dass Reinigungsmechanismen, allen voran die natürliche Reinigung durch Wind, deutlich besser wirken können und somit die Verschmutzung an der Oberflächen reduziert werden kann.

Im Gegensatz zu selbstreinigenden (super)-hydrophoben und (super)hydrophilen Oberflächen, ist die Wasserbelegung an der Oberfläche der vorgeschlagenen Oberflächenbeschichtung reduziert, da sich - vor allem unter Kondensationsbedingungen wie einer hohen Luftfeuchtigkeit - ein Großteil des Wassers in und nicht auf der Schicht befindet. Für die Funktionalität werden darüber hinaus keine extremen Kontakt- oder Benetzungswinkel benötigt.

Im Vergleich zu anderen porösen Schichten, welche über keinen Gradienten der Benetzbarkeit/Hydrophobizität verfügen, führen die zusätzlich in Richtung der Objektoberfläche gerichteten Kapillarkräfte zu einer signifikanten Reduzierung der Wassermenge an der Schichtoberseite. Bei rein hydrophoben porösen Schichten ist hingegen von Wassertropfen mit langer Residenzzeit an der Oberfläche auszugehen, bei rein hydrophilen porösen Schichten können Kapillarkräfte zu einem Anstieg des Wassers in den Poren der Schicht bis hin zur Oberfläche führen. Beide Varianten bieten durch eine langzeitige Benetzung Möglichkeiten zur Ausbildung von kleinen Wasser-Kapillaren zwischen Oberfläche und etwaigen Verunreinigungen wie Staubpartikel. Diese Effekte lassen sich unter Anwendung des hier vorgeschlagenen Gradienten in der Benetzbarkeit minimieren.

Die vorgeschlagene Oberflächenbeschichtung lässt sich unter Verwendung großindustriell erprobter Verfahren auch mit Anti-Reflex-Eigenschaften herstellen und weist effektive, Schmutz-abweisende, insbesondere Staub-abweisende, Eigenschaften auf.

Die nanoporöse Schicht oder Schichtfolge der vorgeschlagenen Oberflächenbeschichtung wird vorzugsweise mit einem Sol-Gel-Verfahren erzeugt. Die Aufbringung des Sols kann dabei in bekannter Weise durch unterschiedliche Techniken, beispielsweise durch Tauchbeschichtung, Rotationsbeschichtung oder durch Aufsprühen, erfolgen. Vorzugsweise ist die nanoporöse Schicht oder Schichtfolge dabei aus Nanopartikeln gebildet. Für die Erzeugung einer größeren Schichtdicke mit hydrophilen Eigenschaften können auch Mikropartikel in das Innere der Schicht eingelagert werden.

Die Wasserspeicherkapazität kann auch durch Verwendung bzw. Einlagerung von Materialien, insbesondere Nano- und/oder Mikropartikeln, in der nanoporösen Schicht- oder Schichtfolge erhöht werden, die Wasser aufnehmen können. Diese Wasseraufnahme kann beispielsweise erfolgen in Form von:
∘ Kristallwasser, Koordinationswasser, Strukturwasser (chemisch gebundenes Wasser); z.B. mittels Natriumsulfat, Mineralien der Zeolithgruppe;
∘ Adsorption an großer innerer und äußerer Oberfläche; z.B. mittels Aerogelen und Xerogelen wie Kieselgel, sowie andere Silikate (z.B. Montmorillonit, Betonite, Palygorskit);
∘ Absorption, z.B. in Polymeren und/oder Kunststoffmaterialien wie Polyamide, Chitosan, Stärke Damit steht in diesem Fall zur Wasseraufnahme nicht nur das Porenvolumen zur Verfügung, sondern auch ein Teil der eingebrachten Materialien.

Als Schichtmaterialien können beispielsweise anorganische Materialien wie SiO₂, Al₂O₃, TiO₂, ZrO₂, MgF₂, ZnO₂ oder CaF₂ dienen, aus denen eine nanoporöse Schicht als Wasserspeicherschicht gebildet werden kann. Für die Erzeugung der hydrophoben Oberfläche können beispielsweise Alkylsilan enthaltende Verbindungen, wie z.B. Methylsilan (CH₆Si), oder auch Fluor enthaltende Verbindung, wie z.B. Fluorsilan (H₃FSi), auf die Oberfläche einer derartigen Schicht aufgebracht oder in diese Schicht infiltriert werden. Derartige Schichten weisen optisch transparente Eigenschaften auf, so dass sie für Anwendungen auf PV-Modulen oder anderen Objekten, die eine entsprechend optisch transparente Beschichtung erfordern, anwendbar sind. Sind derartige optisch transparente Schichten nicht erforderlich, so können auch poröse Schichten aus anderen Materialien, bspw. aus organischem Material, für die Bildung der vorgeschlagenen Oberflächenbeschichtung eingesetzt werden.

Es besteht auch die Möglichkeit, das Erreichen der Taupunktstemperatur an der Oberfläche von Photovoltaik-Modulen oder anderen mit der Oberflächenbeschichtung versehenen und im Freien befindlichen Objekten durch geeignete Maßnahmen hinauszuzögern, um dadurch ein geringeres Wasservolumen aufnehmen zu müssen, also die notwendige Wasserspeicherkapazität zu verringern. Eine Möglichkeit besteht im Einsatz von Mikropartikeln mit gekapselten Phasenwechselmaterialien (PCMs) mit Phasenwechseltemperatur im Bereich des Taupunktes (Wetter-abhängig von Außentemperatur und Luftfeuchtigkeit), hier typischer Weise im Bereich 5°C bis 25 °C. Die bei höheren Temperaturen z.B. flüssigen PCMs beginnen in den Mikropartikeln zu kristallisieren, sobald die Temperaturen nahe am Taupunkt sind und weiter fallen. Die abgegebene latente Wärme heizt die Oberfläche, sodass der Taupunkt nicht oder erst später unterschritten wird. Dies verringert die zu speichernde Taumenge. Eine andere Möglichkeit besteht im Einsatz von Partikeln bzw. Partikelbeschichtungen mit Low-E-Eigenschaften (niedriger IR-Emissivität). Diese verringern die Strahlungskühlung, sodass die Oberfläche gegenüber einer Ausgestaltung ohne derartige Partikel oder Partikelbeschichtungen langsamer auskühlt und der Taupunkt nicht bzw. zu einem späterem Zeitpunkt unterschritten wird. Auch hierdurch die zu speichernde Taumenge reduziert.

Die vorgeschlagene Oberflächenbeschichtung sowie das vorgeschlagene Verfahren finden in allen Bereichen Anwendung, in denen die oberflächliche Anlagerung von Stäuben und/oder Schmutz die Funktionalität der Objekte nachteilig beeinflusst und daher reduziert werden soll. Hierzu zählen auch die genannten Prozessstäube in industriellen Produktionsanlagen wie beispielsweise Allergene in der Lebensmittelproduktion, Farbpulver-Rückstände in der Farbproduktion oder Staubpartikel-Pharmazieprodukte. Weitere Beispiele sind in der Beschreibungseinleitung genannt. Ein besonders hohes Anwendungspotential besteht in der Photovoltaik und in der Solarthermie, da Solarmodule und CSP-Anlagen in zunehmendem Maße in staubigen Umgebungen installiert werden.

### Kurze Beschreibung der Zeichnungen

Die vorgeschlagene Oberflächenbeschichtung und das zugehörige Verfahren werden nachfolgend anhand von Ausführungsbeispielen in Verbindung mit den Zeichnungen nochmals näher erläutert. Hierbei zeigen:
- Fig. 1: eine schematische Darstellung verschiedener Varianten des Schichtaufbaus der vorgeschlagenen Oberflächenbeschichtung; und
- Fig. 2: eine schematische Darstellung des Wirkprinzips der vorgeschlagenen Oberflächenbeschichtung.

### Wege zur Ausführung der Erfindung

Beispiele für den Aufbau der vorgeschlagenen Oberflächenbeschichtung werden im Folgenden am Anwendungsbeispiel des Deckglases eines PV-Moduls aufgeführt. Die Anwendung der vorgeschlagenen Oberflächenbeschichtung ist jedoch nicht auf PV-Module beschränkt, sondern kann auf beliebige Objekte unter Ausnutzung des gleichen Schichtaufbaus übertragen werden. Zentraler Bestandteil der vorgeschlagenen Oberflächenbeschichtung ist dabei die Trennung von Wasser und Partikeln an der Oberfläche durch eine Wassertransportschicht, die Speicherung des Wassers in einer Wasserspeicherschicht und das nachträgliche Ausgasen des Wassers. Diese Prozesse können durch nanoporöse Schichten mit entsprechendem Porenvolumen in der Wasserspeicherschicht und eine vertikal innerhalb der der Schicht variierende Benetzbarkeit/Hydrophobizität von hydrophob an der Schichtoberfläche (atmosphärische Seite) hin zu Hydrophilie im Inneren bzw. auf der Objektseite erreicht bzw. verstärkt werden.

Für den Aufbau der Schicht werden nanoporöse Schichtmaterialien zum effizienten vertikalen Transport von flüssigem und gasförmigem Wasser eingesetzt, beispielsweise basierend auf oxidischen Nanopartikeln oder Nanokristalliten. Die Oberflächenbeschichtung kann als Einschichtsystem mit gradiertem Verlauf der Benetzbarkeit/Hydrophobizität von hydrophob von der Schichtoberfläche (Wassertransportschicht) hin zu hydrophil im Inneren der Schicht bzw. zum Objekt hin (Wasserspeicherschicht) ausgebildet sein. Die Oberflächenbeschichtung kann auch als Mehr-Schicht-System, bestehend aus mindestens zwei Schichten, ausgebildet sein, bei welchem die der Atmosphäre zugewandte Schicht hydrophobe Eigenschaften aufweist (Wassertransportschicht), während die dem Objekt zugewandte Schicht einen hydrophilen Charakter besitzt (Wasserspeicherschicht).

Die Schichtdicke der Wasserspeicherschicht ist an die für die Anwendung und Zielregion zu erwartenden Wasservolumina angepasst. Mit Hilfe von großen Partikeln im Mikrometer-Bereich (z.B. aus Glas), deren Zwischenräume dann mit dem nanoporösen Schichtmaterial aufgefüllt werden, können entsprechend große Volumina erzeugt werden, um genügend Speicherkapazität für Wasser zu erreichen. Die Schichtdicke ist vorzugsweise - soweit es die Funktion der Wasserspeicherschicht mit der notwendigen Speicherkapazität zulässt - entsprechend der gewünschten optischen Eigenschaften als Antireflex-Schicht optimiert. Sie kann hierzu als einzelne λ/4-Schicht oder im Mehr-Schicht-System mit unterschiedlichen Brechungsindizes als zwei λ/4-Schichten ausgebildet sein. Die Wellenlänge λ ist im Anwendungsfall der Photovoltaik für den verwendeten Solarzellentyp und die entsprechende wellenlängenabhängige Quantenausbeute optimiert. Eine Anti-Reflex-Funktion von Mehrschicht-Systemen kann bspw. durch variablen Brechungsindex aufgrund unterschiedlicher Dichten bei verschieden gewählten Partikelgrößen oder unterschiedlich gewählten Partikelmaterialien für die einzelnen Schichten optimiert werden. Die optisch dichtere Schicht ist dabei dem Objekt bzw. Glassubstrat zugewandt. Die Absorptions-/Emissions-Eigenschaften der Schicht bzw. des Schichtstapels werden bei Anwendungen unter freiem Himmel vorzugsweise dahingehend optimiert, dass im Wellenlängenbereich des atmosphärischen Fensters (IR-Strahlung) nur eine möglichst geringe Emission stattfindet und eine damit verbundene Kühlung (radiative cooling) und resultierende Betauung vermieden werden kann.

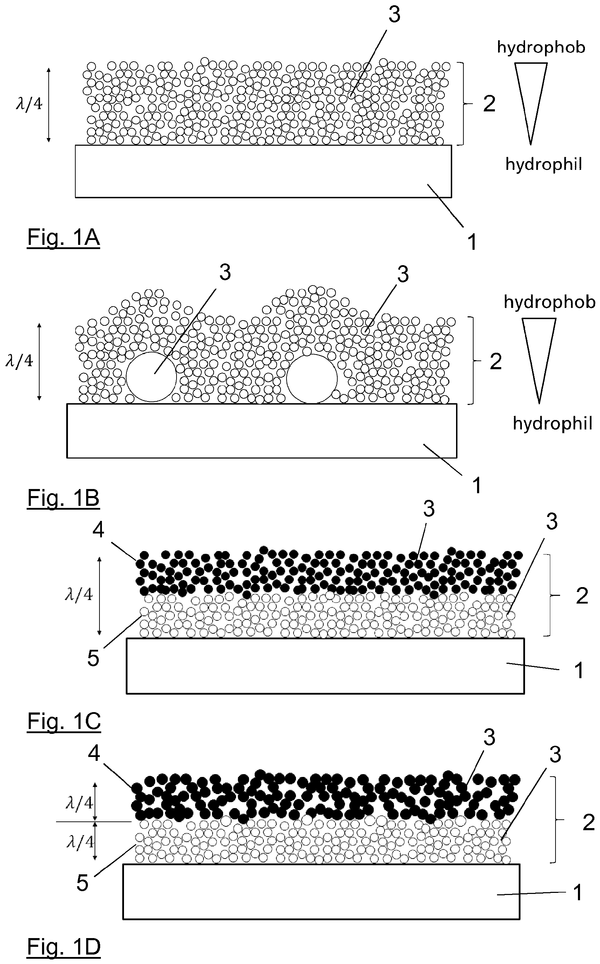

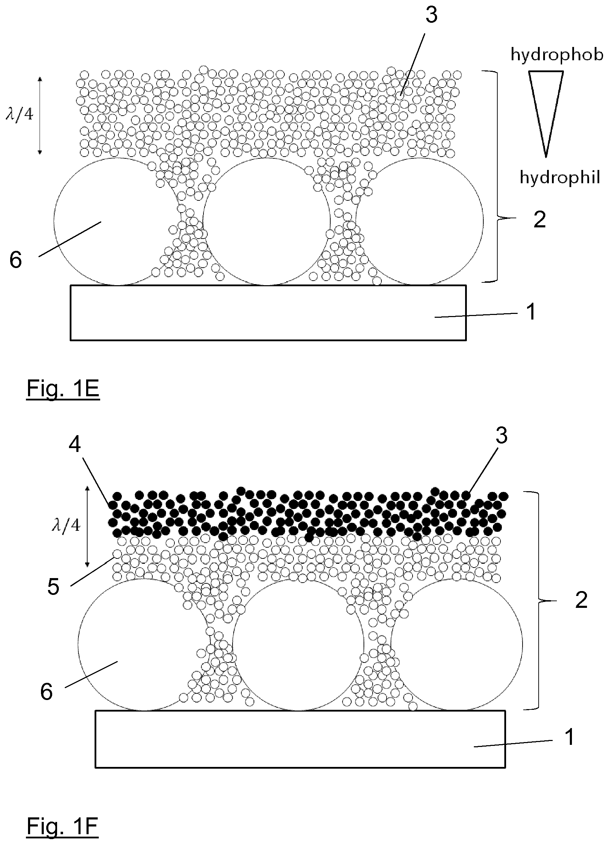

Figur 1 zeigt in den Teilabbildungen A bis F Beispiele für den schematischen Schichtaufbau des Deckglases eines Solarmoduls mit den oben angeführten verschiedenen Konfigurationen des nanoporösen Schichtsystems. In Figur 1A ist hierzu ein Ein-Schicht-System aus einer nanoporösen Schicht 2 auf einem Glassubstrat 1 zu erkennen, die aus oxidischen Nanopartikeln 3 gebildet ist. Die Schicht weist eine Schichtdicke von λ/4 auf, ist somit als Antireflex-Schicht ausgebildet. Die Schicht ist aus monodispersen Nanopartikeln mit einem graduellen Verlauf von hydrophoben zu hydrophilen Eigenschaften ausgebildet, wie dies durch das ebenfalls dargestellte Verlaufsdreieck angedeutet ist.

Figur 1B zeigt ein weiteres Ein-Schicht-System mit der entsprechend angedeuteten Schichtdicke von λ/4, bei dem die nanoporöse Schicht 2 aus oxidischen Nanopartikeln 3 mit bimodaler Größenverteilung ausgebildet ist. Auch hier weist die Schicht einen graduellen Verlauf von hydrophoben zu hydrophilen Eigenschaften auf, wie durch das entsprechende Verlaufsdreieck angedeutet ist.

Figur 1C zeigt ein Beispiel für ein Mehr-Schicht-System aus einem Schichtstapel aus zwei nanoporösen Schichten. Diese Oberflächenbeschichtung ist aus einer unteren hydrophilen Schicht 5 und einer oberen hydrophoben Schicht 4 aus monodispersen Nanopartikeln 3 mit jeweils gleichem Brechungsindex n1 ausgebildet. Die Schichtfolge weist wiederum eine Dicke von λ/4 auf und ist damit als Anti-Reflex-Beschichtung ausgebildet.

Figur 1D zeigt schließlich ein weiteres Beispiel für einen Schichtstapel aus einer unteren hydrophilen nanoporösen Schicht 5 und einer oberen hydrophoben nanoporösen Schicht 4. In diesem Beispiel sind die beiden Schichten aus unterschiedlich großen/dichten Nanopartikeln 2 mit entsprechend unterschiedlichen Brechungsindizes n1 und n2 gebildet, wie dies in der Figur angedeutet ist. Jede der beiden Schichten 4, 5 des Schichtstapels weist hier eine Dicke von λ/4 auf.

Zur Erhöhung der Wasserspeicherkapazität des Inneren der hydrophilen Schicht oder des hydrophilen Schichtbereichs können Mikropartikel in diese Schicht oder diesen Schichtbereich eingebettet werden. Figur 1E zeigt hierzu ein Beispiel für einen Ein-Schicht-Aufbau mit einem graduellen Verlauf von hydrophoben zu hydrophilen Eigenschaften (vgl. Verlaufsdreieck). Durch die auf das Glassubstrat 1 aufgebrachten Mikropartikel 6 beispielsweise aus Glas, zwischen denen dann die oxidischen Nanopartikel 2 eingebracht werden, wird ein entsprechend größeres Speichervolumen erreicht. Dies kann in gleicher Weise bei Ausbildung der Oberflächenbeschichtung aus einem Schichtstapel aus einer hydrophilen Schicht 5 und einer hydrophoben Schicht 4 erfolgen, wobei dann die Mikropartikel 6 in der hydrophilen Schicht 5 eingebettet sind. Die beiden nanoporösen Schichten unterscheiden sich dabei in diesem Beispiel auch in der Partikelgröße bzw. Partikeldichte der Nanopartikel 3 und entsprechend in ihrem Brechungsindex, wie dies in Figur 1F angedeutet ist.

Die funktionalen Eigenschaften der Schichten als Wassertransport- bzw. Wasserspeicherschicht können für spezielle Anwendungsfälle erweitert werden. So kann in einer Ausgestaltung ein Ausheizen des Substrates 1 erfolgen, um die Wasserbelegung in der nanoporösen Schicht 2 zu minimieren und die einwandfreie Funktion der Schicht wieder herzustellen. Dies kann z.B. zyklisch oder nach Bedarf erfolgen. In einer weiteren vorteilhaften Ausgestaltung werden photokatalytisch aktive Nanopartikel aus Materialien wie TiO₂ oder ZnO in substrat-nahen Bereichen der nanoporösen Schichten eingesetzt. Diese können insbesondere bei Lichteinfall mit UV-Anteil den hydrophilen Charakter der substrat-nahen Schichten verstärken. In einer weiteren vorteilhaften Ausgestaltung kann auch eine Funktionalisierung bzw. Plasma-Reinigung des Substrates vor dem Aufbringen der Beschichtung erfolgen, um den hydrophilen Charakter in diesem Bereich sicherzustellen.

Die in Figur 1 angegebenen Schichtdicken von λ/4 können selbstverständlich unter Verzicht auf die Antireflex-Wirkung auch durch eine größere Schichtdicke d (>λ/4) ersetzt werden, falls dies zum Erreichen einer höheren Wasserspeicherkapazität erforderlich ist.

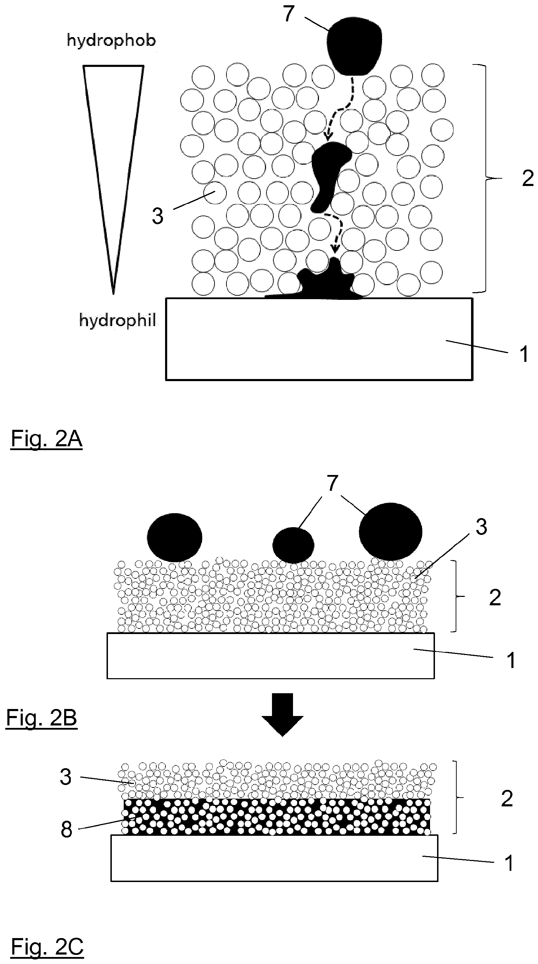

Die Funktionsweise bzw. das Wirkprinzip der vorgeschlagenen Oberflächenbeschichtung wird anhand der Figur 2 nochmals veranschaulicht. In der Figur ist hierbei in Teilabbildung 2A ein Glassubstrat 1 mit einer nanoporösen Schicht 2 aus Nanopartikeln 3 zu erkennen, die einen graduellen Verlauf von hydrophoben zu hydrophilen Eigenschaften von der Oberfläche zum Substrat hin aufweist. Dieser graduelle Verlauf ist durch das Verlaufsdreieck in der Figur angedeutet. Ein mikroskopischer Wassertropfen 8, der auf die Oberfläche der Oberflächenbeschichtung trifft, bewegt sich von der Oberfläche zum Glassubstrat, getrieben von der Gewichtskraft und durch den Hydrophobizität-Gradienten unterstützte Kapillarkräfte. Dies ist schematisch durch Pfeile in der Figur 2A veranschaulicht. Figur 2B zeigt hierbei den Anfangszustand mit den mikroskopischen Wassertropfen 6 auf der nanoporösen Schicht 2, die die Oberfläche der nanoporösen Schicht aufgrund deren hydrophober Eigenschaften nicht benetzen. Nach kurzer Zeit werden diese Wassertropfen 6 in das Innere der Schicht transportiert und dort gespeichert, wie dies durch das eingelagerte Wasser 8 in der Figur 2C angedeutet ist.

Auf diese Weise werden Zementationsprozesse an der Oberfläche vermieden, die zu hartnäckigen Verschmutzungen führen können. Das in der Wasserspeicherschicht gespeicherte Wasser wird bei entsprechender Wärmeeinwirkung durch Verdampfung wieder entfernt. Dies kann vor allem bei Anwendungen in der Photovoltaik oder Solar-Thermie alleine durch die Sonneneinstrahlung bewirkt werden. Es besteht auch die Möglichkeit, durch gezielte wiederholte Wärmeeinwirkung die Wasserspeicherschicht in regelmäßigen oder unregelmäßigen Abständen wieder trockenzulegen.

### Bezugszeichenliste

- 1: Glassubstrat
- 2: Nanoporöse Schicht
- 3: Nanopartikel
- 4: Obere hydrophobe Schicht
- 5: Untere hydrophile Schicht
- 6: Mikropartikel
- 7: Mikroskopischer Wassertropfen
- 8: eingelagertes Wasser

## Patentansprüche

1. Oberflächenbeschichtung mit verringerter Verschmutzungsanfälligkeit, insbesondere Oberflächenbeschichtung eines Photovoltaikmoduls, die durch eine nanoporöse Schicht oder Schichtfolge (2) gebildet ist, die eine hydrophobe Oberfläche aufweist,
**dadurch gekennzeichnet,**
**dass** die nanoporöse Schicht oder Schichtfolge (2) im Inneren hydrophil als Wasserspeicherschicht mit einer Wasserspeicherkapazität von wenigstens 60*10⁻⁶ l/m² ausgebildet ist.

2. Oberflächenbeschichtung nach Anspruch 1,
**dadurch gekennzeichnet,**
**dass** die nanoporöse Schichtfolge (2) aus wenigstens zwei übereinander liegenden Schichten gebildet ist, von denen eine obere Schicht (4) hydrophob und eine untere Schicht (5) hydrophil ausgebildet ist.

3. Oberflächenbeschichtung nach Anspruch 1,
**dadurch gekennzeichnet,**
**dass** die nanoporöse Schicht (2) einen graduellen Verlauf der hydrophoben und hydrophilen Eigenschaften ausgehend von der Oberfläche bis ins Innere der Schicht aufweist.

4. Oberflächenbeschichtung nach einem der Ansprüche 1 bis 3,
**dadurch gekennzeichnet,**
**dass** die nanoporöse Schicht oder Schichtfolge (2) aus einem optisch transparenten Material gebildet ist, insbesondere im Wellenlängenbereich zwischen 300 und 1200 nm.

5. Oberflächenbeschichtung nach Anspruch 4,
**dadurch gekennzeichnet,**
**dass** die nanoporöse Schicht oder Schichtfolge (2) als Antireflexbeschichtung für optische Strahlung ausgebildet ist.

6. Oberflächenbeschichtung nach einem der Ansprüche 1 bis 4,
**dadurch gekennzeichnet,**
**dass** die nanoporöse Schicht oder Schichtfolge (2) einen hydrophilen Bereich mit einer Dicke von mindestens 120 nm aufweist.

7. Oberflächenbeschichtung nach einem der Ansprüche 1 bis 6,
**dadurch gekennzeichnet,**
**dass** die nanoporöse Schicht oder Schichtfolge (2) eine Porosität zwischen 30-70% aufweist

8. Oberflächenbeschichtung nach einem der Ansprüche 1 bis 7,
**dadurch gekennzeichnet,**
**dass** die nanoporöse Schicht oder Schichtfolge (2) eine Sol-Gel-Schicht oder -Schichtfolge ist.

9. Oberflächenbeschichtung nach einem der Ansprüche 1 bis 8,
**dadurch gekennzeichnet,**
**dass** die nanoporöse Schicht oder Schichtfolge (2) aus Nanopartikeln (3) gebildet ist.

10. Oberflächenbeschichtung nach einem der Ansprüche 1 bis 9,
**dadurch gekennzeichnet,**
**dass** im Inneren der nanoporösen Schicht oder Schichtfolge (2) Mikropartikel (6) eingelagert sind.

11. Oberflächenbeschichtung nach einem der Ansprüche 1 bis 10,
**dadurch gekennzeichnet,**
**dass** in die nanoporöse Schicht oder Schichtfolge (2) Nano- und/oder Mikropartikel eingelagert sind, die Wasser aufnehmen können.

12. Oberflächenbeschichtung nach einem der Ansprüche 1 bis 11,
**dadurch gekennzeichnet,**
**dass** in die nanoporöse Schicht oder Schichtfolge (2) Mikropartikel mit einem gekapselten Phasenwechselmaterial eingelagert sind, die einer Unterschreitung einer Taupunktstemperatur an der Oberfläche der nanoporösen Schicht oder Schichtfolge (2) durch Wärmeabgabe entgegenwirken.

13. Oberflächenbeschichtung nach einem der Ansprüche 1 bis 11,
**dadurch gekennzeichnet,**
**dass** in die nanoporöse Schicht oder Schichtfolge (2) Partikel oder Partikel mit Beschichtungen eingelagert sind, die eine niedrige IR-Emissivität aufweisen.

14. Verfahren zur Verringerung der Verschmutzungsanfälligkeit einer Objektoberfläche, insbesondere der Oberfläche von Photovoltaikmodulen,
bei dem eine Oberflächenbeschichtung nach einem der mehreren der vorangehenden Patentansprüche auf die Objektoberfläche aufgebracht wird.

15. Verfahren nach Anspruch 14,
**dadurch gekennzeichnet,**
**dass** die Oberflächenbeschichtung wiederholt aufgeheizt wird, um im Inneren der Beschichtung gespeichertes Wasser zu entfernen.

## Claims

1. A surface coating with reduced susceptibility to contamination, in particular surface coating of a photovoltaic module, which is formed by a nanoporous layer or layer sequence (2) which has a hydrophobic surface,
**characterized in that**
the nanoporous layer or layer sequence (2) is designed in its interior hydrophilic as a water storage layer with a water storage capacity of at least 60*10⁻⁶ l/m².

2. The surface coating according to claim 1, **characterized in that**
the nanoporous layer sequence (2) is formed from at least two superimposed layers of which an upper layer (4) is hydrophobic and a lower layer (5) is hydrophilic.

3. The surface coating according to claim 1, **characterized in that**
the nanoporous layer (2) has a gradual progression of the hydrophobic and hydrophilic properties starting from the surface towards the interior of the layer.

4. The surface coating according to any one of claims 1 to 3,
**characterized in that**
the nanoporous layer or layer sequence (2) is formed from an optically transparent material, particularly in the wavelength range between 300 and 1200 nm.

5. The surface coating according to claim 4, **characterized in that**
the nanoporous layer or layer sequence (2) is formed as an anti-reflection coating for optical radiation.

6. The surface coating according to any one of claims 1 to 4,
**characterized in that**
the nanoporous layer or layer sequence (2) has a hydrophilic region having a thickness of at least 120 nm.

7. The surface coating according to any one of claims 1 to 6,
**characterized in that**
the nanoporous layer or layer sequence (2) has a porosity between 30 and 70 %.

8. The surface coating according to any one of claims 1 to 7,
**characterized in that**
the nanoporous layer or layer sequence (2) is a sol-gel layer or layer sequence.

9. The surface coating according to any one of claims 1 to 8,
**characterized in that**
the nanoporous layer or layer sequence (2) is formed from nanoparticles (3).

10. The surface coating according to any one of claims 1 to 9,
**characterized in that**
microparticles (6) are embedded in the interior of the nanoporous layer or layer sequence (2).

11. The surface coating according to any one of claims 1 to 10,
**characterized in that**
nano- and/or microparticles which can absorb water are embedded in the nanoporous layer or layer sequence (2).

12. The surface coating according to any one of claims 1 to 11,
**characterized in that**
microparticles with an encapsulated phase change material which function to prevent dropping below a dew point temperature on the surface of the nanoporous layer or layer sequence (2) by releasing heat are embedded in the nanoporous layer or layer sequence (2).

13. The surface coating according to any one of claims 1 to 11,
**characterized in that**
particles or particles with coatings which have a low IR emissivity are embedded in the nanoporous layer or layer sequence (2).

14. A method for reducing a susceptibility to contamination of an object surface, in particular the surface of photovoltaic modules, in which a surface coating according to one or more of the preceding claims is applied to the object surface.

15. The method according to claim 14,
**characterized in that**
the surface coating is heated repeatedly to remove water stored in the interior of the coating.

## Revendications

1. Revêtement de surface avec une sensibilité réduite aux salissures, notamment revêtement de surface d'un module photovoltaïque, qui est formé par une couche ou une série de couches (2) nanoporeuses, qui présente une surface hydrophobe,
**caractérisé en ce que**
la couche ou la série de couches nanoporeuses est configurée à l'intérieur de manière hydrophile comme une couche de rétention d'eau avec une capacité de rétention d'eau d'au moins 60*10⁻⁵ l/m².

2. Revêtement de surface selon la revendication 1, **caractérisé en ce que**
la série de couches nanoporeuses (2) est constituée d'au moins deux couches situées l'une au-dessus de l'autre, desquelles une couche supérieure (4) a une configuration hydrophobe et une couche inférieure (5) a une configuration hydrophile.

3. Revêtement de surface selon la revendication 1, **caractérisé en ce que**
la couche nanoporeuse (2) présente un cours graduel des propriétés hydrophobes et hydrophiles à partir de la surface jusqu'à l'intérieur de la couche.

4. Revêtement de surface selon une des revendications 1 à 3,
**caractérisé en ce que**
la couche ou la série de couches nanoporeuses (2) est constituée d'un matériau optique transparent, notamment dans la plage de longueur d'onde comprise entre 300 et 1200 nm.

5. Revêtement de surface selon la revendication 4, **caractérisé en ce que**
la couche ou la série de couches nanoporeuses (2) est configuré comme un revêtement antireflet pour un rayonnement optique.

6. Revêtement de surface selon une des revendications 1 à 4,
**caractérisé en ce que**
la couche ou la série de couches nanoporeuses (2) présente une zone hydrophile avec une épaisseur d'au moins 120 nm.

7. Revêtement de surface selon une des revendications 1 à 6,
**caractérisé en ce que**
la couche ou la série de couches nanoporeuses (2) présente une porosité comprise entre 30 et 70 %.

8. Revêtement de surface selon une des revendications 1 à 7,
**caractérisé en ce que**
la couche ou la série de couches nanoporeuses (2) est une couche ou une série de couches sol-gel.

9. Revêtement de surface selon une des revendications 1 à 8,
**caractérisé en ce que**
la couche ou la série de couches nanoporeuses (2) est constitués de nanoparticules (3).

10. Revêtement de surface selon une des revendications 1 à 9,
**caractérisé en ce que**
à l'intérieur de la couche ou de la série de couches nanoporeuses (2) des microparticules (6) sont incorporées.

11. Revêtement de surface selon une des revendications 1 à 10,
**caractérisé en ce que**
dans la couche ou la série de couches nanoporeuses (2), des nano-et/ou microparticules sont incorporées, qui peuvent absorber de l'eau.

12. Revêtement de surface selon une des revendications 1 à 11,
**caractérisé en ce que**
dans la couche ou la série de couche nanoporeuses (2) des microparticules avec un matériau à changement de phases encapsulé sont incorporées, qui contrebalancent un sous-dépassement d'une température de point de rosée sur la surface de la couche ou de la série de couches nanoporeuses (2) par dissipation thermique.

13. Revêtement de surface selon une des revendications 1 à 11,
**caractérisé en ce que**
dans la couche ou la série de couches nanoporeuses (2) sont incorporés des particules ou des particules avec des revêtements, qui présentent une émissivité IR moindre.

14. Procédé de réduction de la sensibilité aux salissures d'une surface d'objet, notamment de la surface de modules photovoltaïques, dans lequel un revêtement de surface de selon une ou plusieurs des revendications précédentes est appliqué sur la surface d'objet.

15. Procédé selon la revendication 14,
**caractérisé en ce que**
le revêtement de surface est chauffé et de manière répétée, afin d'éliminer l'eau accumulée à l'intérieur du revêtement.
